Europäisches Patentamt

(19) European Patent Office

Office européen des brevets

(11) Numéro de publication: **0 053 526**
**B1**

## (12) FASCICULE DE BREVET EUROPEEN

(45) Date de publication du fascicule du brevet:
**15.02.84**

(21) Numéro de dépôt: **81401634.1**

(22) Date de dépôt: **16.10.81**

(51) Int. Cl.³: **H 03 K 17/60,** H 03 K 17/73,
H 03 K 3/286

(54) **Commutateur à commande par impulsions en ouverture et en fermeture, et son intégration.**

(30) Priorité: **21.11.80 FR 8024798**

(43) Date de publication de la demande:
**09.06.82 Bulletin 82/23**

(45) Mention de la délivrance du brevet:
**15.02.84 Bulletin 84/7**

(84) Etats contractants désignés:
**DE FR GB IT NL SE**

(56) Documents cités:
**DE - A - 2 914 767**
**US - A - 3 449 598**
**US - A - 3 551 699**
**US - A - 4 221 980**

**POLYTECHNISCH TIJDSCHRIFT, vol. 21E, no. 4, février 1966 LA HAYE (NL) A.C. KALISVAART: "Impulsvormer voor een fotodiode in een ponsbandaftaster", pages 125E-129E**

(73) Titulaire: **THOMSON-CSF, 173, Boulevard Haussmann, F-75379 Paris Cedex 08 (FR)**

(72) Inventeur: **Rischmuller, Klaus, THOMSON-CSF SCPI 173, bld Haussmann, F-75360 Paris Cedex 08 (FR)**

(74) Mandataire: **de Beaumont, Michel et al, THOMSON-CSF SCPI 173, Bld Haussmann, F-75379 Paris Cedex 08 (FR)**

Commutateur à commande par impulsions en ouverture et en fermeture et son intégration

La présente invention concerne un commutateur à commande par impulsions en ouverture et en fermeture et la réalisation sous forme de circuit intégré d'un tel commutateur. La présente invention vise plus particulièrement des commutateurs de puissance pouvant bloquer des tensions relativement importantes et laisser passer des courants de forte intensité.

Actuellement les commutateurs électroniques à état solide pour courants unidirectionnels se divisent en trois familles principales. Ces familles vont être analysées ci-après en relation avec le mode de commande de l'interrupteur.

La première famille comprend les dispositifs du type thyristor, thyristor à amplification de gâchette, et analogues. Pour commander en fermeture ces commutateurs, il convient d'appliquer sur leur gâchette une impulsion de courant. Ensuite le commutateur reste conducteur tant qu'une tension est appliquée entre ses bornes principales. De tels commutateurs ne peuvent être ouverts simplement tandis qu'une tension est appliquée à leurs bornes. Pour ce faire, il convient de prévoir des circuits de commutation forcée relativement complexes.

La deuxième famille comprend les dispositifs du type transistor ou transistors en montage Darlington. Ces dispositifs sont commandables en fermeture et en ouverture. Pour les commander, il convient d'appliquer un courant de base qui doit être maintenu pendant toute la durée de conduction. Pour l'ouverture, il suffit d'annuler ce courant de base. Les dispositifs de cette deuxième famille ont donc comme avantage par rapport à ceux de la première famille qu'ils ne nécessitent pas de circuit à commutation forcée pour leur ouverture. Par contre leurs inconvénients résident dans le fait que le courant de base doit être appliqué pendant toute la durée de conduction ce qui complique le circuit de commande et entraine une consommation dans ce circuit de commande. Pour limiter cette consommation, on utilise couramment dans les circuits de commande de transistors Darlington des convertisseurs dans le cas d'alimentation sur batterie pour limiter la tension d'alimentation du courant de base et réduire ainsi la dissipation dans le circuit de commande.

Des commutateurs comportant montages Darlington mixte tel que ceux énoncés dans le préambule de la revendication I sont connus du document DE-A- 2 914 767.

La troisième famille comprend les dispositifs du type thyristor ouvrable par la gâchette. Ces dispositifs nécessitent pour leur fermeture une impulsion de courant de gâchette d'amplitude raisonnable et de courte durée. Par contre, l'ouverture de tels dispositifs nécessite l'application d'un courant de gâchette en sens inverse de très forte amplitude, sensiblement de l'ordre de grandeur du courant principal traversant le dispositif.

Un objet de la présente invention est de prévoir un nouveau type de commutateur pouvant être commandé par une impulsion d'amplitude raisonnable aussi bien en ouverture qu'en fermeture, ce qui simplifie considérablement les circuits de commande et permet d'utiliser directement des signaux de commande fournis par des circuits intégrés de commande sans prévoir d'interfaces complexes.

Un autre objet de la présente invention est de prévoir un tel commutateur associable de façon simple à un circuit de sécurité peu complexe.

Un autre objet de la présente invention est de prévoir un tel commutateur réalisable sous forme intégrée.

Un commutateur à commande par impulsions en ouverture et en fermeture selon la présente invention comprend: des bornes principales correspondant au collecteur et à l'émetteur d'un premier transistor de puissance d'un premier type de conduction (NPN ou PNP) et un deuxième transistor du deuxième type de conduction connecté par son émetteur au collecteur du premier transistor et par son collecteur à la base du premier transistor; une première résistance insérée entre la base et l'émetteur du premier transistor; un troisième transistor du premier type de conduction dont l'émetteur est connecté à l'émetteur du premier transistor, la base au point de connexion de la base du premier transistor et du collecteur du second par l'intermédiaire d'une seconde résistance, et le collecteur à la base du deuxième transistor; une troisième résistance disposée entre la base et l'émetteur du second transistor; et une borne de commande reliée à la base du troisième transistor.

Ce commutateur peut être commandé par une impulsion appliquée à la borne de commande. Dans le cas où les transistors du premier type sont des transistors NPN, le dispositif est commandé à la fermeture par une impulsion positive. Il reste ensuite conducteur puis est commandé à l'ouverture par application d'une impulsion négative. Le rapport entre l'amplitude du courant de commande et l'amplitude du courant traversant le commutateur est de l'ordre du produit des gains des trois transistors. Ainsi, même si ces gains sont relativement faibles, notamment pour le second transistor, l'amplitude de l'impulsion de commande est au moins 100 fois inférieure à l'amplitude du courant traversant le commutateur.

Ces objets, caractéristiques et avantages ainsi que d'autres de la présente invention seront exposés plus en détail dans la description suivante de modes de réalisation particuliers faite en relation avec les figures jointes parmi lesquelles:

la figure 1 représente sous forme de circuit un commutateur selon la présente invention;
la figure 2A représente un circuit de commande et de sécurité associable à un commutateur selon la présente invention;
la figure 2B représente des formes d'ondes destinées à assister l'exposé du fonctionnement du circuit de la figure 2A;

la figure 3 représente une vue en coupe très schématique d'un mode de réalisation sous forme intégrée d'un commutateur selon la présente invention; et

la figure 4 représente une vue de dessus très schématique d'un mode de réalisation d'un commutateur intégré selon la présente invention.

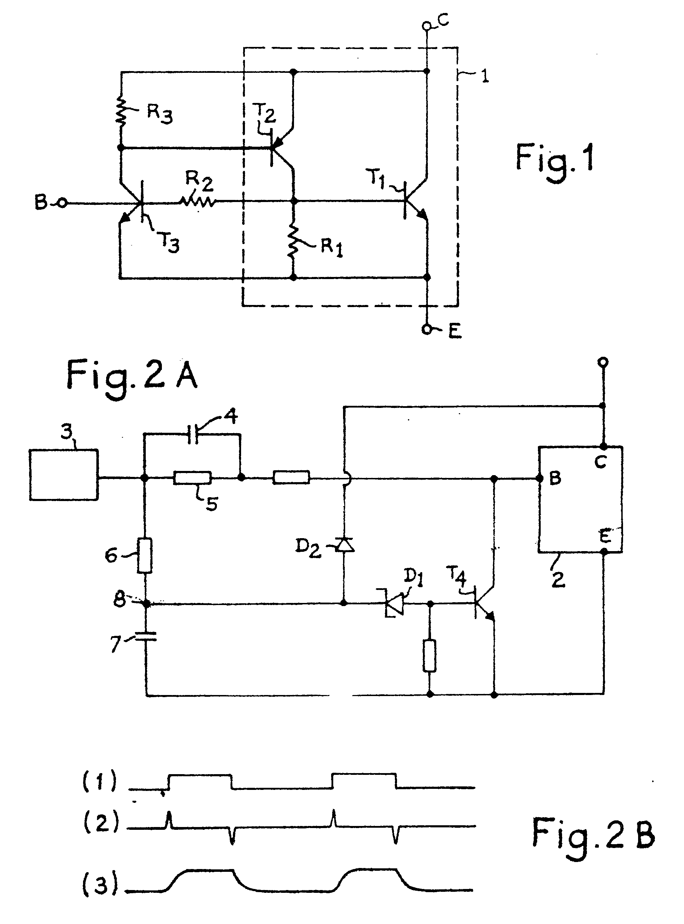

La figure 1 représente un mode de réalisation sous forme d'un assemblage de composants discrets d'un commutateur selon la présente invention. Ce commutateur comprend tout d'abord l'ensemble 1 d'un premier transistor T1, d'un second transistor T2 et d'une résistance R1 agencés selon le montage parfois appelé Darlington mixte. Le premier transistor T1 est de type NPN. Son collecteur est connecté à une borne principale C et son émetteur à une borne principale E du commutateur. Le second transistor est de type PNP. Son émetteur est connecté à la borne C et son collecteur à la base du transistor T1. Une résistance R1 est disposée entre la base et l'émetteur du transistor T1. Toutefois, contrairement au montage en Darlington mixte classique, cet ensemble 1 n'est connecté directement à aucune borne de sortie. Le commutateur selon la présente invention comprend, outre l'ensemble 1, un troisième transistor T3 de même type que le premier transistor T1, à savoir NPN. La base de ce transistor T3 est connectée par l'intermédiaire d'une résistance R2 à la base du transistor T1 et au collecteur du transistor T2. Le collecteur de ce transistor T3 est connecté à la base du transistor T2. L'émetteur du transistor T3 est connecté à l'émetteur du transistor T1. La base et l'émetteur du transistor T2 sont connectés par l'intermédiaire d'une résistance R3. La borne de commande B de ce commutateur est reliée à la base du transistor T3.

En supposant qu'initialement le transistor T1 est bloqué, l'application d'une tension positive à l'électrode de commande B entraîne la mise en conduction du troisième transistor T3 puis celle du transistor T2 et par conséquent celle du transistor T1. Par suite, la tension base/émetteur du transistor T1 devient positive et alimente la base du transistor T3 par l'intermédiaire de la résistance R2. Ainsi, le système reste en conduction tant qu'un courant circule dans le transistor T1 même si le courant de commande sur le transistor T3 a disparu. Il est donc possible de mettre en conduction cet ensemble par application d'une impulsion positive dont l'amplitude par rapport à celle du courant principal qui doit traverser le transistor T1 se trouve dans un rapport au moins égal au produit des gains des trois transistors T1, T2 et T3.

Pour couper le transistor T1, il suffit de bloquer le transistor T3. Ceci peut être effectué en appliquant à la borne B une tension propre à annuler la tension base/émetteur du transistor T3, c'est-à-dire un courant correspondant au rapport entre la valeur de la tension base/émetteur du transistor T1 et la résistance R2. On choisira la valeur de la résistance R2 de sorte que les amplitudes des impulsions de courant d'ouverture et de fermeture soient du même ordre de grandeur. Ensuite, en l'absence d'une impulsion de commande positive sur la borne B, le commutateur reste bloqué.

A titre d'exemple, on notera que la demanderesse a réalisé sous forme d'assemblage de composants discrets le commutateur selon la présente invention représenté en figure 1. Pour ce montage on a utilisé comme transistor T1 un transistor dit BUV 18, (courant de collecteur en saturation de 80 ampères avec possibilité de pointe à 120 ampères), comme transistor T2 un transistor ESM 624 pouvant supporter un courant de collecteur en saturation de 10 ampères, et comme transistor T3 un transistor dit BD 303 de faible puissance. La résistance R1 avait une valeur de 1 ohm, la résistance R2 de 27 ohms et la résistance R3 de 4,7 ohms. Dans le cas où le circuit externe est tel que le courant susceptible de passer dans le transistor T1, quand celui-ci est conducteur, est de l'ordre de 120 ampères, on a noté qu'une impulsion de courant sur la borne B d'une valeur de l'ordre de quelques dizaines de milliampères, par exemple 50 mA et d'une durée de quelques microsecondes est suffisante. En effet, on peut considérer que le gain du montage est le produit du gain des trois transistors utilisés, c'est-à-dire dans le cas particulier exposé ci-dessus $10 \times 20 \times 50 = 10.000$. Un courant de 50 mA est donc en théorie capable de commander à la fermeture le dispositif jusqu'à des intensités de l'ordre de 500 A.

On notera que, même si les gains des divers transistors utilisés sont plus faibles (ce qui risque d'être le cas dans un montage intégré, notamment pour le transistor T2), on pourra encore obtenir des déclenchements pour des impulsions d'intensité raisonnable. Dans l'exemple précédent, si le gain du transistor T2 était ramené à une valeur de l'ordre de l'unité, et que les gains des transistors T1 et T3 étaient respectivement de l'ordre de 10 et de 20, on aurait un gain total de l'ordre de 200, c'est-à-rie que pour commander à la fermeture un courant de 100 ampères il suffirait d'une tension de commande de 500 mA.

Pour ouvrir le commutateur il faut annuler la tension base/émetteur du transistor T3. Il convient donc d'appliquer une impulsion de courant de faible durée (quelques micro-secondes) d'une valeur égale à la tension base/émetteur du transistor T1 divisée par la valeur de la résistance R2. Dans l'exemple précédent, la tension base/émetteur du transistor T1 en conduction est de l'ordre de 1,2 volts, la résistance R2 de 27 ohms. Il suffira donc d'appliquer une impulsion négative d'une valeur voisine de 45 mA. On notera que cette intensité de l'impulsion de coupure dépend peu des transistors spécifiques utilisés, les tensions base/émetteur en conduction étant toujours du même ordre de grandeur. Le dispositif selon la présente invention sera donc simple à couper dans tout mode de réalisation, notamment dans une réalisation en circuit intégré.

En résumé, on a vu dans le cas de l'exemple précédent que l'on pouvait fermer le dispositif avec une impulsion de courant d'une intensité de l'ordre de 50 milli-ampères et l'ouvrir avec une impulsion de courant d'une intensité de l'ordre de 45 milli-ampères.

A titre de comparaison, on notera que, pour un même courant dans le circuit principal de l'ordre de 120 ampères, les courants de commande devraient être

– pour un ensemble de transistors en montage Darlington: de l'ordre de 1,2 ampère à la fermeture et de l'ordre de –100 mA à –2 ampères à l'ouverture avec la différence notable que le courant de fermeture doit être maintenu pendant toute la durée de conduction du commutateur;
– pour un dispositif du type thyristor à ouverture par la gâchette: une impulsion de l'ordre de 1 ampère à la fermeture et de l'ordre de 20 à 100 ampères à l'ouverture;
– pour un dispositif du type thyristor à amplification de gâchette: un courant en impulsion de l'ordre de 100 mA pour la fermeture, sans possibilité simple d'ouverture autrement que par interruption du courant aux bornes principales du commutateur.

La figure 2A représente un circuit de commande et de sécurité par un commutateur selon la présente invention. Ce commutateur est représenté sous forme de bloc et est désigné par la référence 2. Seules ses bornes d'accès B, C et E sont illustrées.

Ce commutateur peut être simplement commandé directement par la sortie d'un circuit intégré 3, par exemple un circuit de modulation de largeur d'impulsions (PWM) fournissant un signal en créneau à bas niveau quand on souhaite que le commutateur soit ouvert et un signal à haut niveau quand on souhaite que le commutateur soit fermé. Le signal de sortie du circuit 3 est transmis à un circuit dérivateur comprenant en parallèle un condensateur 4 et une résistance 5. Le signal de sortie du modulateur 3 est représenté par la courbe (1) de la figure 2B et le signal de sortie du dérivateur 4, 5 est représenté par la courbe (2) de la figure 2B. On obtient donc une impulsion positive au début de chaque créneau de commande de conduction et une impulsion négative à la fin de chacun de ces créneaux. Ces impulsions sont propres comme on l'a vu précédemment à commander directement la borne B du commutateur 2.

La figure 2A représente également un circuit de sécurité destiné à ouvrir le commutateur dès que la tension entre ses bornes principales C et E dépasse un seuil prédéterminé pendant une phase de conduction. Ce circuit de sécurité comprend une résistance 6 en série avec un condensateur 7 connecté à la masse. Le point intermédiaire entre cette résistance et ce condensateur est désigné par la référence 8. On obtient ainsi au point 8 un signal représenté par la courbe (3) de la figure 2B dont la montée en tension est retardée par rapport au signal de sortie du modulateur représenté par la courbe (1) de cette figure 2B. Le point intermédiaire 8 est connecté par une diode Zener $D_1$ de tension de seuil $V_Z$ à la base d'un transistor T4 dont le collecteur est connecté à la borne B et l'émetteur à la masse. Le point 8 est également connecté à la borne C par l'intermédiaire d'une diode D2 polarisée de la façon représentée. En outre, le circuit comprend diverses résistances usuelles de polarisation et d'adaptation dont certaines sont représentées. Avec ce montage, dès que la tension entre collecteur et émetteur du commutateur 2 selon la présente invention dépasse la tension Zener $V_Z$ de la diode D1, le transistor T4 devient conducteur, la borne B est connectée à la masse et il en résulte une coupure du commutateur. Il est donc possible avec le commutateur selon l'invention de réaliser un circuit de sécurité particulièrement simple grâce au fait que ce commutateur peut être commandé à l'ouverture par des impulsions de faible intensité.

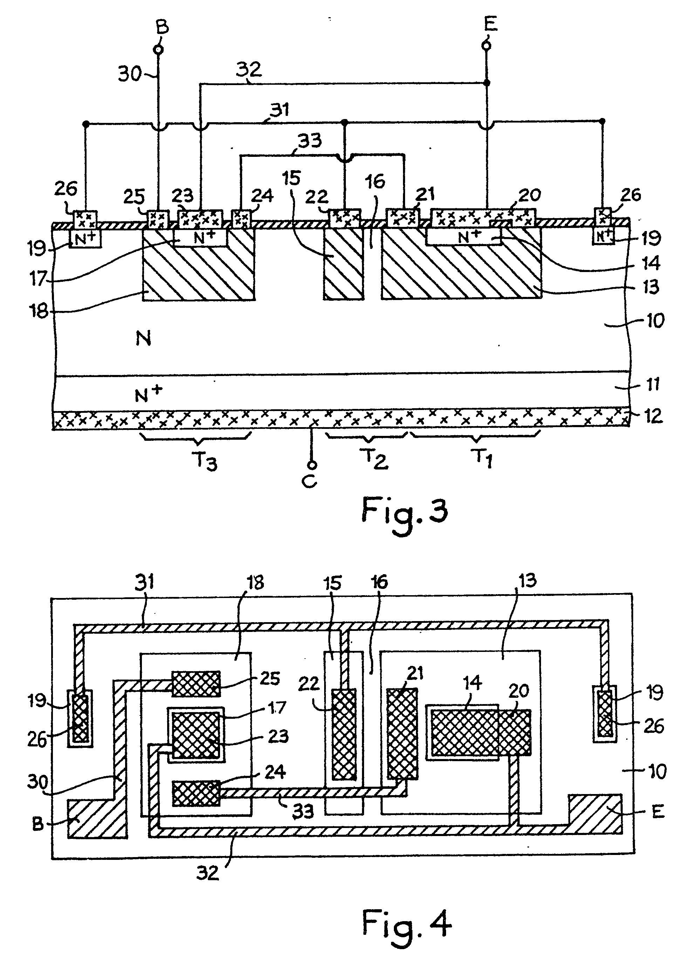

Les figures 3 et 4 présentent respectivement une vue en coupe et une vue de dessus d'une intégration possible d'un commutateur selon l'invention. Ce mode d'intégration est un exemple possible parmi d'autres modes envisageables. On notera que les figures 3 et 4 sont fortement schématiques et que la vue de dessus ne correspond pas strictement à la vue en coupe, la disposition de certaines zones ayant été modifiées entre ces deux figures pour les rendre plus lisibles et plus parlantes. D'autre part, conformément à l'usage dans le domaine de la représentation des dispositifs semiconducteurs, les différentes zones et couches n'ont pas été représentées à l'échelle les unes par rapport aux autres mais bien au contraire certaines ont été dilatées ou réduites pour faciliter la lisibilité des figures.

Dans la figure 3, le commutateur est réalisé sur un substrat semiconducteur de type N (couramment du silicium); les zones hachurées de façon lâche représentent des zones auxquelles on a conféré le type de conductivité P; les zones hachurées de façon serrée représentent des couches de $SiO_2$; les zones marquées de croix représentent des métallisations. Dans la figure 4, les zones hachurées représentent des métallisations reposant sur des zones isolées (par exemple de la silice) et les zones marquées de hachures croisées représentent des métallisations en contact avec le semiconducteur sous-jacent. Dans la partie droite de la figure, on peut voir le transistor T1 réalisé sous forme d'un transistor planar vertical (transverse la plaquette de silicium). Le collecteur de ce transistor comprend le substrat 10 de type N, et une zone surdopée 11 de reprise de contact sur laquelle est déposée une couche de métallisation 12. La couche de base du transistor T1 est formée par une zone diffusée 13 de type P et son émetteur est constitué d'une zone 14 de type N+ formée à l'intérieur de la zone 13. Le transistor T2 est du type latéral et comprend une zone 15 de type P comme zone d'émetteur, une portion 16 du substrat 10 comme zone de base et une partie de la zone 13 de type P comme zone de collecteur. Le transistor T3 est réalisé sous forme verticale comme le transistor T1 et comprend une zone d'émetteur de type N⁺ 17 disposée à l'intérieur d'une zone de base de type P 18, le collecteur correspondant à des portions des couches 10 et 11. On trouve également dans cette structure des zones de type N⁺ formées à partir de la face supérieure du substrat, désignées collectivement par la référence 19, et destinées à former des résistances entre des métallisations sur la face supérieure et la métallisation de la face inférieure. Le transistor T1 occupe une surface beaucoup plus importante que celle occupée par le transistor T3 étant donné que le transistor T1 doit être capable de supporter des tensions et de laisser passer des courants importants. En pratique la différence de dimension sera nettement plus marquée que celle qui est schématisée sur la figure.

Les métallisations en contact avec le silicium sous-jacent comprennent une métallisation 20 à cheval sur les couches 13 et 14, une métallisation 21 sur une portion de la couche 13 éloignée de celle sur laquelle repose la couche 20, une métallisation 22 sur la couche 15, une métallisation 23 sur la couche 17, des métallisations 24 et 25 éloignées l'une de l'autre sur la couche 18, et des métallisations 26 sur les couches 19. D'autres métallisations isolées joignent ces premières métallisations à d'autres ou à des plots de contact. Une première métallisation isolée 30 relie la métallisation de base 25 du transistor T3 à un plot de connexion B. Une deuxième métallisation isolée 31 relie les métallisations 26 et 22, c'est-à-dire qu'elle relie l'émetteur du transistor T2 au collecteur du transistor T1 par l'intermédiaire d'une résistance correspondant à l'épaisseur du substrat. Cette résistance peut être minimisée en accroissant la profondeur des diffusions de type N⁺ 19. Une troisième métallisation isolée 32 relie les métallisations 20 et 23 entre elles et à un plot E, c'est-à-dire à la borne principale E du commutateur. La connexion entre les métallisations 20 et 23 correspond à la connexion entre les émetteurs des transistors T1 et T3, la métallisation 20 reliant l'émetteur et la base du transistor T1 correspondant pour sa part à la connexion entre base et émetteur du transistor T1 par l'intermédiaire d'une résistance R1. Une quatrième métallisation isolée 33 relie les métallisations 21 et 24. Cette métallisation 33 correspond à une connexion entre le collecteur du transistor T2 et la base du transistor T3 par l'intermédiaire d'une résistance R2 qui correspond à la zone de la couche 18 comprise entre les métallisations 24 et 25.

Comme pourra le noter l'homme de l'art, la réalisation de cette intégration entraîne l'existence de résistances réparties autres que les résistances R1, R2 et R3. Notamment, on retrouvera des résistances entre la base du transistor T2 et le collecteur du transistor T3 ainsi qu'entre l'émetteur du transistor T2 et le collecteur du transistor T1. Les formes et dimensions de la structure intégrée réelle seront conçues pour minimiser ces résistances parasites qui toutefois affectent peu le fonctionnement du dispositif. D'autres schémas d'intégration sont possibles et produiront d'autres résistances parasites. On notera également qu'il est possible d'intégrer seulement une partie des composants de la figure 1; par exemple il a déjà été proposé dans la technique l'ensemble constituant le Darlington mixte 1.

La présente invention n'est pas limitée aux modes de réalisation qui ont été explicitement décrits. Elle en englobe au contraire les diverses variantes et généralisations incluses dans le domaine des revendications ci-après.

**Revendications**

1. Commutateur à commande par impulsions en ouverture et en fermeture comprenant des bornes principales correspondant au collecteur et à l'émetteur d'un premier transistor de puissance (T1) d'un premier type de conduction et un deuxième transistor (T2) d'un deuxième type de conduction opposé au premier connecté par son émetteur au collecteur du premier transistor et par son collecteur à la base du premier transistor, une première résistance (R1) étant insérée entre base et émetteur du premier transistor, caractérisé en ce qu'il comprend en outre un troisième transistor (T3) du premier type de conduction dont l'émetteur est connecté à l'émetteur du premier transistor, la base au point de connexion de la base du premier transistor et du collecteur du deuxième transistor par l'intermédiaire d'une seconde résistance (R2), et le collecteur à la base du deuxième transistor; une troisième résistance (R3) étant reliée entre base et émetteur du second transistor; et une borne de commande étant reliée à la base du troisième transistor.

2. Commutateur selon la revendication 1, caractérisé en ce que les transistors du premier type sont des transistors NPN et le transistor du deuxième type est un transistor PNP.

3. Commutateur selon la revendication 1, caractérisé en ce que le gain du second transistor est de l'ordre de l'unité.

4. Commutateur selon la revendication 1, caractérisé en ce qu'il est réalisé sous forme d'un circuit assemblant des composants discrets.

5. Commutateur selon la revendication 1, caractérisé en ce que certains au moins des composants le constituant sont rassemblés en un circuit intégré.

6. Commutateur selon la revendication 5 réalisé sous forme de composant unitaire sur un substrat semiconducteur d'un premier type de conductivité, caractérisé en ce que les premiers et troisième transistors sont du type transistor planar transverses au substrat, le second transistor étant réalisé sous forme de transistor latéral, sa base correspondant à une zone du substrat et son collecteur à une zone du deuxième type de conductivité qui correspond également à la base du premier transistor.

7. Commutateur selon la revendication 1, caractérisé en ce que sa borne de commande (B) reçoit la sortie d'un circuit de commande à modulation de largeur d'impulsions (3) par l'intermédiaire d'un circuit différentiateur (4, 5) fournissant une impulsion d'une première direction lors des montées des créneaux de commande et une impulsion de deuxième polarité lors des descentes des créneaux de commande.

8. Commutateur selon la revendication 1, comprenant en outre un circuit de sécurité destiné à le mettre automatiquement dans l'état de coupure alors qu'il se trouve dans l'état de conduction et que la tension entre les bornes principales dépasse une valeur de seuil prédéterminée, ce circuit de sécurité étant caractérisé en ce qu'il comprend un quatrième transistor (T4) connecté entre la borne de commande (B) et une borne principale (E) du commutateur, la base de ce quatrième transistor (T4) étant connectée à l'autre borne principale du commutateur par l'intermédiaire d'une diode Zener (D1) en série avec une diode de redressement (D2), le point de connexion entre la diode Zener (D1) et la diode de redressement (D2) étant relié à un circuit tel qu'un condensateur (7) de retard d'une tension correspondant à une commande de conduction.

**Patentansprüche**

1. Schalter, der durch Impulse in den geöffneten und in den geschlossenen Zustand steuerbar ist und Hauptanschlüsse umfasst, welche dem Kollektor und dem Emitter eines ersten, Leistungstransistors (T1) eines ersten Leitungstyps bzw. eines zweiten Transistors (T2) eines zweiten, dem ersten entgegengesetzten Leitungstyps entspricht, welcher an seinem Emitter mit dem Kollektor des ersten Transistors und an seinem Kollektor mit der Basis des ersten Transistors verbunden ist, wobei ein erster Widerstand (R1) zwischen die Basis und den Emitter des ersten Transistors eingefügt ist, dadurch gekennzeichnet, dass er ferner einen dritten Transistor (T3) des ersten Leitungstyps umfasst, dessen Emitter mit dem Emitter des ersten Transistors verbunden ist, dessen Basis mit dem Verbindungspunkt zwischen der Basis des ersten Transistors und dem Kollektor des zweiten Transistors über einen zweiten Widerstand (R2) verbunden ist und dessen Kollektor mit der Basis des zweiten Transistors verbunden ist, wobei ein dritter Widerstand (R3) zwischen die Basis und den Emitter des zweiten Transistors eingefügt ist und wobei ein Steueranschluss mit der Basis des dritten Transistors verbunden ist.

2. Schalter nach Anspruch 1, dadurch gekennzeichnet, dass die Transistoren des ersten Typs NPN-Transistoren sind und der Transistor des zweiten Typs ein PNP-Transistor ist.

3. Schalter nach Anspruch 1, dadurch gekennzeichnet, dass die Verstärkung des zweiten Transistors ungefähr gleich 1 ist.

4. Schalter nach Anspruch 1, dadurch gekennzeichnet, dass sie in Form einer Schaltung aus diskreten Bauteilen aufgebaut ist.

5. Schalter nach Anspruch 1, dadurch gekennzeichnet, dass wenigstens bestimmte Bauteile, aus denen er aufgebaut ist, in einer integrierten Schaltung vereinigt sind.

6. Schalter nach Anspruch 5, welcher in Form eines einzigen Bauteils auf einem Halbleitersubstrat eines ersten Leitungstyps verwirklicht ist, dadurch gekennzeichnet, dass der erste und der dritte Transistor Planartransistoren sind, die quer zu dem Substrat angeordnet sind, wobei der zweite Transistor in Form eines Lateraltransistors verwirklicht ist, dessen Basis einer Zone des Substrats und dessen Kollektor einer Zone des zweiten Leitungstyps entspricht, welcher ferner der Basis des ersten Transistors entspricht.

7. Schalter nach Anspruch 1, dadurch gekennzeichnet, dass sein Steueranschluss (B) das Ausgangssignal einer Pulsdauermodulations-Steuerschaltung (3) über eine Differenzierschaltung (4, 5) empfängt, die einen Impuls einer ersten Richtung während der Anstiegsflanken der Rechteck-Steuerimpulse und einen Impuls einer zweiten Polarität während der Abfallflanken der Rechteck-Steuerimpulse liefert.

8. Schalter nach Anspruch 1, der ferner eine Sicherheitsschaltung umfasst, welche dazu bestimmt ist, ihn automatisch in den Öffnungszustand zu bringen, wenn er sich im leitenden Zustand befindet und die Spannung zwischen den Hauptanschlüssen einen vorbestimmten Grenzwert überschreitet, wobei diese Sicherheitsschaltung dadurch gekennzeichnet ist, dass sie einen vierten Transistor (T4) umfasst, der zwischen den Steueranschluss (B) und einen Hauptanschluss (E) des Schalters eingefügt ist, wobei die Basis dieses vierten Transistors (T4) mit dem anderen Hauptanschluss des Schalters über eine Zenerdiode (D1) in Reihe mit einer Gleichrichterdiode (D2) verbunden ist, und wobei der Verbindungspunkt zwischen der Zenerdiode (D1) und der Gleichrichterdiode (D2) mit einer Schaltung wie einem Kondensator (7) zur Verzögerung einer Spannung, die einer Steuerung in den leitenden Zustand entspricht, verbunden ist.

**Claims**

1. Switch with pulse control for breaking and for closing comprising main terminals corresponding to the collector and the emitter of a first power transistor (T1) of a first conductivity type and of a second transistor (T2) of a second conductivity type opposite to the first connected by its emitter to the collector of the first transistor and by its collector to the base of the first transistor, a first resistor (R1) being inserted between the base and emitter of the first transistor, characterized in that it further comprises a third transistor (T3) of the first conductivity type of which the emitter is connected to the emitter of the first transistor, the base to the point of connection of the base of the first transistor and of the collector of the second transistor via a second resistor (R2) and the collector to the base of the second transistor, a third resistor (R3) being connected between the base and emitter of the second transistor, and a control terminal being connected to the base of the third transistor.

2. Switch according to claim 1, characterized in that the transistors of the first type are NPN transistors and the transistor of the second type is a PNP transistor.

3. Switch according to claim 1, characterized in that the gain of the second transistor is of the order of unity.

4. Switch according to claim 1, characterized in that it is realized in the form of a circuit of discrete components.

5. Switch according to claim 1, characterized in that at least some of the components making up said switch are united in an integrated circuit.

6. Switch according to claim 5 realized in the form of a unitary component on a semiconductor substrate of a first conductivity type, characterized in that the first and third transistors are of the planar transistor type transverse to the substrate, the second transistor being realized in the form of a lateral transistor, its base corresponding to a zone of the substrate and its collector to a zone of the second conductivity type which corresponds likewise to the base of the first transistor.

7. Switch according to claim 1, characterized in that its control terminal (B) receives the output of a pulse width modulation control circuit (3) via a differentiating circuit (4, 5) supplying a pulse of a first direction during the leading edges of the rectangular control pulses and a pulse of a second polarity during the trailing edges of the rectangular control pulses.

8. Switch according to claim 1, further comprising a safety circuit intended to bring said switch automatically into the break condition when it is in the conducting condition and when the voltage between the main terminals exceeds a predetermined threshold value, said safety circuit being characterized in that it comprises a fourth transistor (T4) connected between the control terminal (B) and a main terminal (E) of the switch, the base of said fourth transistor (T4) being connected to the other main terminal of the switch via a zener diode (D1) in series with a rectifying diode (D2), the point of connection between the zener diode (D1) and the rectifying diode (D2) being connected to a circuit such as a capacitor (7) for delaying a voltage corresponding to a conduction control.

Fig.1

Fig.2 A

(1)

(2)

(3)

Fig.2 B

Fig. 3

Fig. 4

11